# EUROPEAN PATENT APPLICATION

(11) **EP 4 287 533 A1**
(43) Date of publication of application: **06.12.2023**
(21) Application number: 21927255.6
(22) Date of filing: 26.02.2021
(51) Int. Cl.: H04L 1/00

(54) **DESIGN METHOD FOR FORWARD ERROR CORRECTION (FEC) AND RELATED DEVICE**

(71) Applicant: Huawei Technologies Co., Ltd., Shenzhen, Guangdong 518129 (CN)
(72) Inventor: LI, Xiaowei, Shenzhen, Guangdong 518129 (CN); ZHANG, Zhenxing, Shenzhen, Guangdong 518129 (CN); JIN, Junhao, Shenzhen, Guangdong 518129 (CN); WEI, Zhigui, Shenzhen, Guangdong 518129 (CN)
(74) Representative: Goddar, Heinz J.
(86) International application number: PCT/CN2021/078108
(87) International publication number: WO 2022/178818

(57) **Abstract**

This application provides a forward error correction code FEC design method and a related device. The method includes: determining a quantity of transmission lanes for transmitting data, and determining a plurality of FEC working areas based on the quantity of transmission lanes, where a quantity of the plurality of FEC working areas is the same as the quantity of transmission lanes, the transmission lane is for transmitting the data, and the FEC working area is for performing check and error correction on the data; evenly allocating the data on the transmission lane to each of the plurality of FEC working areas; and processing, by using the plurality of FEC working areas, the data received by each of the plurality of FEC working areas. Based on this solution, FEC working areas whose quantity is the same as a quantity of transmission lanes are selected, so that an interface circuit scale and design complexity can be reduced, and production costs can be reduced.

## Description

### TECHNICAL FIELD

This application relates to the field of communication technologies, and in particular, to a forward error correction code FEC design method and a related device.

### BACKGROUND

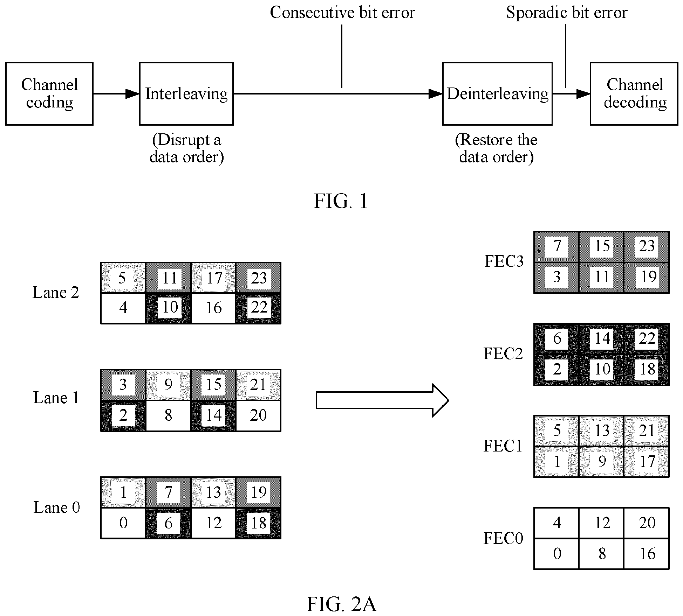

Forward error correction (forward error correction, FEC) or channel coding (channel coding) is a technology for controlling a transmission error in a unidirectional communication system. Error recovery is performed by sending additional information along with data, to reduce a bit error rate. In the FEC, data on each lane (lane) is interleaved to a plurality of FEC working areas, and burst errors are distributed to a plurality of FEC blocks, so that a burst error correction capability on each lane can be further improved. As shown in FIG. 1, consecutive bit errors occur on a transmission lane in a data transmission process. After performing a de-interleaving operation, a receive end converts the consecutive bit errors into sporadic bit errors, so that error correction easily succeeds during channel decoding. Reed-Solomon (Reed-Solomon, RS) code is FEC code suitable for correcting such burst errors, and is widely used in various commercial scenarios, such as high-density digital video disc (digital video disc, DVD), Blu-ray disc, digital subscriber line (digital subscriber line, DSL), digital video broadcast (digital video broadcast, DVB), and the like.

An interface service is applied to various scenarios. An interface includes a plurality of transmission lanes, and different quantities of transmission lanes need to be used in different scenarios. However, in an existing protocol, regardless of how many transmission lanes are used, data is interleaved to a fixed quantity of FEC working areas. As a result, when a quantity of used transmission lanes is different, a data interleaving status is also different, increasing an interface circuit scale, design complexity, and production costs.

Therefore, how to unify a data interleaving form and a data arrangement structure on each transmission lane when different quantities of transmission lanes are used to transmit data, to reduce the interface circuit scale, the design complexity, and the production costs is a problem to be urgently resolved currently.

### SUMMARY

This application provides a forward error correction code FEC design method and a related device. FEC working areas whose quantity is the same as that of transmission lanes are used, and data on a transmission lane is evenly allocated to each FEC working area, so that a data arrangement structure on each transmission lane can be unified. An interface circuit scale and design complexity are reduced, and production costs are effectively reduced.

According to a first aspect, a forward error correction code FEC design method is provided, and the method includes: determining a quantity of transmission lanes for transmitting data, and determining a plurality of FEC working areas based on the quantity of transmission lanes, where a quantity of the plurality of FEC working areas is the same as the quantity of transmission lanes, the transmission lane is for transmitting the data, and the FEC working area is for performing check and error correction on the data; evenly allocating the data on the transmission lane to each of the plurality of FEC working areas; and processing, by using the plurality of FEC working areas, the data received by each of the plurality of FEC working areas.

In the solution provided in this application, the data on the transmission lane is processed by using the FEC working area that matches the transmission lane, and the data on the transmission lane is evenly allocated to each FEC working area. It can be ensured that each FEC working area receives an equal amount of data per unit time. Because processing performance and a delay of each FEC working area are the same, structures of the FEC block and link transport blocks on each transmission lane after processing by using the FEC working area are the same. A periodicity of a link transport block boundary is also the same, that is, a data arrangement structure on each transmission lane is the same. In this way, an interface circuit scale and design complexity can be reduced, and production costs can be reduced.

With reference to the first aspect, in a possible implementation of the first aspect, the data on each transmission lane is divided to obtain a plurality of data blocks, where each data block includes X characters, and X is a positive integer greater than 1; and the X characters included in each data block are evenly allocated to the plurality of FEC working areas.

In the solution provided in this application, to facilitate processing of the data on the transmission lane, the data on the transmission lane needs to be divided, to obtain the plurality of data blocks; and when the data on the transmission lane is evenly allocated to the FEC working area, instead of simply performing correspondence between one transmission lane and one FEC working area and allocating all data on the transmission lane to the FEC working area for processing, the X characters included in one data block on each transmission lane are allocated to the plurality of FEC working areas one by one. In this way, data processed by the FEC workspace each time comes from a plurality of transmission lanes, thereby improving an error correction capability.

With reference to the first aspect, in a possible implementation of the first aspect, if the plurality of FEC working areas are in an encoding state, each of the plurality of FEC working areas performs calculation each time the X characters are received, to obtain Y FEC check bits corresponding to the X characters; or if the plurality of FEC working areas are in a decoding state, each of the plurality of FEC working areas performs check and error correction on the X characters by using Y FEC check bits corresponding to every received X characters.

In the solution provided in this application, the FEC working area may complete data processing based on a state that the FEC working area is in. To be specific, in the encoding state, the FEC working area performs calculation on the X characters obtained through mapping by each transmission lane to obtain the Y FEC check bits. It is easy to understand that data processed by the FEC working area comes from different transmission lanes. Compared with data that is processed by the FEC working area and that comes from the same transmission lane, consecutive bit errors can be converted into sporadic bit errors, which improves the error correction capability. Similarly, in the decoding state, the FEC working area uses the Y FEC check bits to check and correct the X characters mapped from each transmission lane.

With reference to the first aspect, in a possible implementation of the first aspect, a data sequence is inserted between transport blocks transmitted on each of the transmission lanes, where the transport block includes Z data blocks, the data sequence is for delimiting the data transmitted on the transmission lane, and Z is a positive integer greater than 1.

In the solution provided in this application, to further improve efficiency of processing a data stream on a transmission lane, more layers of structural division may be performed on the data transmitted on each transmission lane. The data sequence may be inserted between the transmitted transport blocks. The data sequence is not encoded, and is for delimiting the data transmitted on the transmission lane, aligning data between lanes, initializing a scrambling seed, and the like.

With reference to the first aspect, in a possible implementation of the first aspect, a scramble reset sequence SR is included between the transport blocks transmitted on each of the transmission lanes, the transport block includes Z FEC blocks, and the FEC block includes the X characters and the Y FEC check bits, where X, Y, and Z are positive integers greater than 1.

With reference to the first aspect, in a possible implementation of the first aspect, the X characters included in the data block are equal to an amount of data processed each time in any one of the plurality of FEC working areas, where the amount of data processed by the FEC working area each time is the amount of data received by the FEC working area in a unit time.

With reference to the first aspect, in a possible implementation of the first aspect, the data received by the plurality of working areas and the FEC check bit obtained through calculation are inversely mapped to the transmission lane, and each of the transmission lanes includes a plurality of FEC blocks, where each of the plurality of FEC blocks includes the X characters and the Y FEC check bits.

With reference to the first aspect, in a possible implementation of the first aspect, the FEC blocks on each transmission lane is divided to obtain a plurality of transport blocks, and an SR is inserted between two adjacent transport blocks, where each transport block includes Z FEC blocks, and Z is a positive integer greater than 1.

With reference to the first aspect, in a possible implementation of the first aspect, each of the plurality of FEC working areas has same processing performance and a same processing delay, and receives a same amount of to-be-processed data in a unit time.

According to a second aspect, a data processing apparatus is provided, including: a determining unit, configured to determine a quantity of transmission lanes for transmitting data, and determine a plurality of FEC working areas based on the quantity of transmission lanes, where a quantity of the plurality of FEC working areas is the same as the quantity of transmission lanes, the transmission lane is for transmitting the data, and the FEC working area is for performing check and error correction on the data; an allocation unit, configured to evenly allocate the data on the transmission lane to each of the plurality of FEC working areas; and a processing unit, configured to process, by using the plurality of FEC working areas, the data received by each of the plurality of FEC working areas.

With reference to the second aspect, in a possible implementation of the second aspect, the allocation unit is specifically configured to: divide the data on each transmission lane to obtain a plurality of data blocks, where each data block includes X characters, and X is a positive integer greater than 1; and evenly allocate the X characters included in each data block to the plurality of FEC working areas.

With reference to the second aspect, in a possible implementation of the second aspect, the processing unit is specifically configured to: if the plurality of FEC working areas are in an encoding state, perform, by using each of the plurality of FEC working areas, calculation each time the X characters are received, to obtain Y FEC check bits corresponding to the X characters; or if the plurality of FEC working areas are in a decoding state, perform, by using each of the plurality of FEC working areas, check and error correction on the X characters by using Y FEC check bits corresponding to every received X characters.

With reference to the second aspect, in a possible implementation of the second aspect, the processing unit is further configured to insert a data sequence between transport blocks transmitted on each of the transmission lanes, where the transport block includes Z data blocks, the data sequence is for delimiting the data transmitted on the transmission lane, and Z is a positive integer greater than 1.

With reference to the second aspect, in a possible implementation of the second aspect, a scramble reset sequence SR is included between the transport blocks transmitted on each of the transmission lanes, the transport block includes Z FEC blocks, and the FEC block includes the X characters and the Y FEC check bits, where X, Y, and Z are positive integers greater than 1.

With reference to the second aspect, in a possible implementation of the second aspect, the X characters included in the data block are equal to an amount of data processed each time in any one of the plurality of FEC working areas, where the amount of data processed by the FEC working area each time is the amount of data received by the FEC working area in a unit time.

With reference to the second aspect, in a possible implementation of the second aspect, the allocation unit is further configured to inversely map the data received by the plurality of working areas and the FEC check bits obtained through calculation to the transmission lane, where each of the transmission lanes includes a plurality of FEC blocks, and each of the plurality of FEC blocks includes the X characters and the Y FEC check bits.

With reference to the second aspect, in a possible implementation of the second aspect, the processing unit is further configured to divide the FEC blocks on each transmission lane to obtain a plurality of transport blocks, and insert an SR between two adjacent transport blocks, where each transport block includes Z FEC blocks, and Z is a positive integer greater than 1.

With reference to the second aspect, in a possible implementation of the second aspect, each of the plurality of FEC working areas has same processing performance and a same processing delay, and receives a same amount of to-be-processed data in a unit time.

According to a third aspect, this application provides a data processing apparatus, where the data processing apparatus includes a processor and a transmission interface, and the processor is configured to invoke computer instructions stored in a memory, to perform the method provided in the first aspect or with reference to any implementation of the first aspect.

According to a fourth aspect, this application provides a computer storage medium, where the computer storage medium stores a computer program, and when the computer program is executed by a computer or a processor, a procedure of the method provided in the first aspect or with reference to any implementation of the first aspect can be implemented.

According to a fifth aspect, this application provides a computer program product. The computer program product includes instructions. When the instructions are executed by a computer or a processor, the computer or the processor can perform the procedure of the method provided in the first aspect or with reference to any implementation of the first aspect.

### BRIEF DESCRIPTION OF DRAWINGS

FIG. 1 is a schematic diagram of a principle of forward error correction according to an embodiment of this application;
FIG. 2A is a schematic diagram of interleaving of three-lane data transmission according to an embodiment of this application;
FIG. 2B is a schematic structural diagram of an arrangement of three-lane data transmission according to an embodiment of this application;
FIG. 3Ais a schematic diagram of interleaving of four-lane data transmission according to an embodiment of this application;
FIG. 3B is a schematic structural diagram of an arrangement of four-lane data transmission according to an embodiment of this application;
FIG. 4 is a schematic diagram of a system architecture according to an embodiment of this application;
FIG. 5 is a schematic flowchart of a forward error correction code design method according to an embodiment of this application;
FIG. 6 is a schematic diagram of data block division according to an embodiment of this application;
FIG. 7 is a schematic diagram of FEC working area encoding according to an embodiment of this application;
FIG. 8 is a schematic structural diagram of an FEC block according to an embodiment of this application;
FIG. 9 is a schematic structural diagram of data transmitted on a transmission lane according to an embodiment of this application;
FIG. 10 is a schematic diagram of data mapping and transmission between a transmission lane and an FEC working area according to an embodiment of this application;
FIG. 11A is a schematic diagram of data processing in a one-lane mode according to an embodiment of this application;
FIG. 11B is a schematic structural diagram of data transmission in a one-lane mode according to an embodiment of this application;
FIG. 12A is a schematic diagram of data processing in a two-lane mode according to an embodiment of this application;
FIG. 12B is a schematic structural diagram of data transmission in a two-lane mode according to an embodiment of this application;
FIG. 13 is a schematic structural diagram of a data processing device according to an embodiment of this application; and
FIG. 14 is a schematic structural diagram of a computing device according to an embodiment of this application.

### DESCRIPTION OF EMBODIMENTS

The following clearly and completely describes the technical solutions in this application with reference to the accompanying drawings. Apparently, the described embodiments are merely some rather than all of embodiments of this application. All other embodiments obtained by a person of ordinary skill in the art based on embodiments of this application without creative efforts shall fall within the protection scope of this application.

Some terms and related technologies in this application are first described with reference to accompanying drawings, to help a person skilled in the art has a better understanding.

In embodiments of this application, a transmission lane is specifically a lane for transmitting data, and a specific form of the transmission lane may be a wired transmission lane, or may be a wireless transmission lane. A transmission interface, for example, a high definition multimedia interface (high definition multimedia interface, HDMI), is configured to transmit data by using a plurality of transmission lanes. Different quantities of transmission lanes may be used for data transmission based on different application scenarios. For example, to transmit standard-definition video data, two transmission lanes may be selected, and to transmit high-definition video data, four transmission lanes may be selected.

In embodiments of this application, an FEC working area is specifically a hardware circuit, and is for performing calculation and check and error correction on data. An amount of data processed by each FEC working area is referred to as an FEC block. That is, an amount of data processed by an FEC working area each time is the same as an amount of data included in an FEC block.

In embodiments of this application, data interleaving is specifically referred to mapping data on a transmission lane to an FEC working area, that is, allocating data on each transmission lane to a plurality of FEC working areas.

In embodiments of this application, a data arrangement structure is structural division of data transmitted on a transmission lane. The transmission lane is configured to transmit data, and to-be-transmitted data includes characters, where one data block includes X characters, and one FEC block includes X characters and Y check bits. The Y check bits correspond to the X characters. One transport block (which may also be referred to as a link transport block) includes Z FEC blocks, and one SR is inserted between every two adjacent transport blocks. The SR may also be some character sequences, but the SR is not encoded and is for delimiting a transport block, initialize a scrambling seed, and the like.

To facilitate understanding of this application, related technical knowledge in embodiments of this application is first described herein.

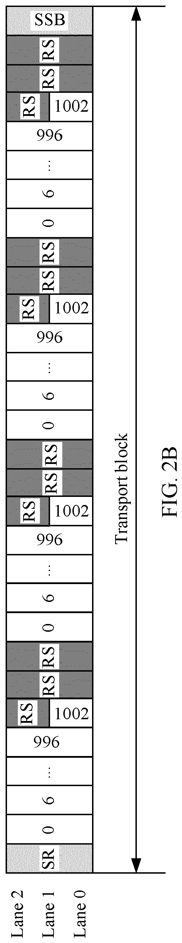

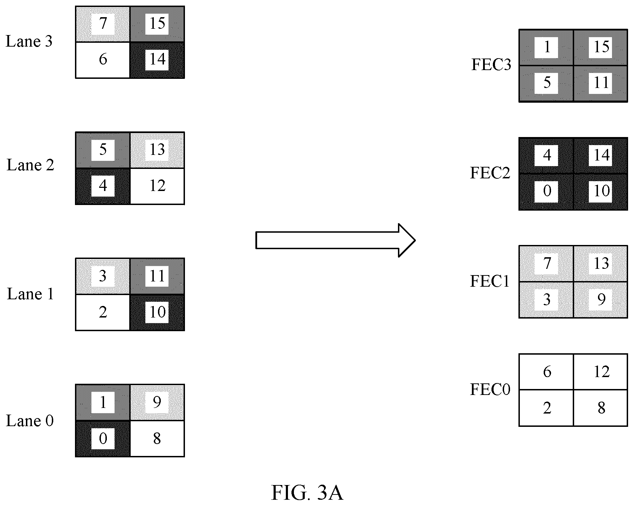

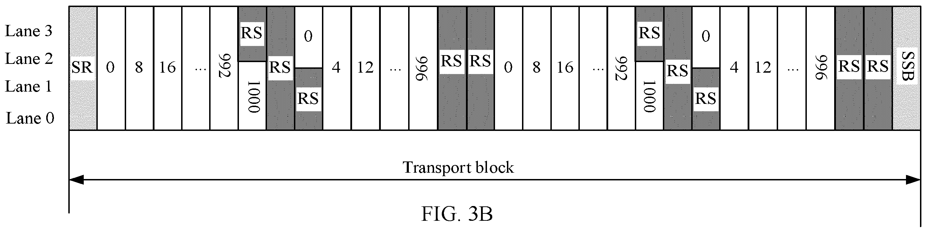

In a scenario in which data is transmitted by using a plurality of lanes, because a quantity of FEC working areas used by the plurality of lanes is fixed, data interleaving statuses are different when quantities of transmission lanes are different. In a case that three transmission lanes are used to transmit data, a data interleaving status is shown in FIG. 2A. Data on the three transmission lanes is interleaved into four different FEC working areas by using four clock cycles. Each FEC working area performs calculation on data obtained by interleaving to obtain a check bit, and then each FEC working area remaps the check bit and the FEC block obtained by the calculation to the previous three transmission lanes. A data arrangement structure on each lane is shown in FIG. 2B. Data between a scramble reset (scramble reset, SR) special character and another start super block (start super block, SSB) is referred to as a data block, and the data block includes not only valid data, but also includes a check bit (that is, an RS check bit in the figure) obtained by the FEC working area through calculation. In this way, after a receive end receives the data, the check bit included in the data block can be used to perform check and error correction on the data in the transport block. In a case that four transmission lanes are used to transmit data, a data interleaving status is shown in FIG. 3A. Data on the four transmission lanes is interleaved into four different FEC working areas by using two clock cycles. Each FEC working area performs calculation on data obtained by interleaving to obtain a check bit, and then each FEC working area remaps the check bit and the FEC block obtained by the calculation to the previous four transmission lanes. A data arrangement structure on each lane is shown in FIG. 3B. Similar to FIG. 2B, data between an SR and an SSB is also referred to as a transport block, and the transport block also includes a check bit for performing check and error correction on the data in the transport block.

It can be learned that, when all data on the transmission lane is interleaved to the four FEC working areas, interleaving manners used in the three-lane transmission mode and the four-lane transmission mode are greatly different, and amounts of data processed in each FEC working area per unit time are different. Processing delays are also different. In addition, as shown in FIG. 2B and FIG. 3B, for each transmission lane, a location of a check bit is different, and a boundary of a transport block is also different. As a result, an entire data arrangement structure varies greatly. If the transmission interface needs to support both the three-lane transmission mode and the four-lane transmission mode, an interface circuit scale and design complexity are increased, and entire production costs are also increased.

To resolve the foregoing problem, this application provides a forward error correction code FEC design method and a related device. In this method, data on a transmission lane is interleaved by using FEC working areas whose quantity is the same as that of selected transmission lanes. Data on the transmission lane is evenly allocated to each FEC working area, and calculation, and check and error correction is performed on data obtained by interleaving by using each FEC working area, so that a same amount of data processed by each FEC working area in a unit time can be ensured, the location of a check bit on each transmission lane is the same, and the boundary of the transport block is the same. Therefore, the interface circuit scale and the design complexity are reduced, and the production costs are effectively reduced.

The technical solutions in embodiments of this application may be applied to various scenarios in which a quantity of transmission lanes needs to be flexibly selected for data transmission, for example, video or audio data is transmitted by using an HDMI.

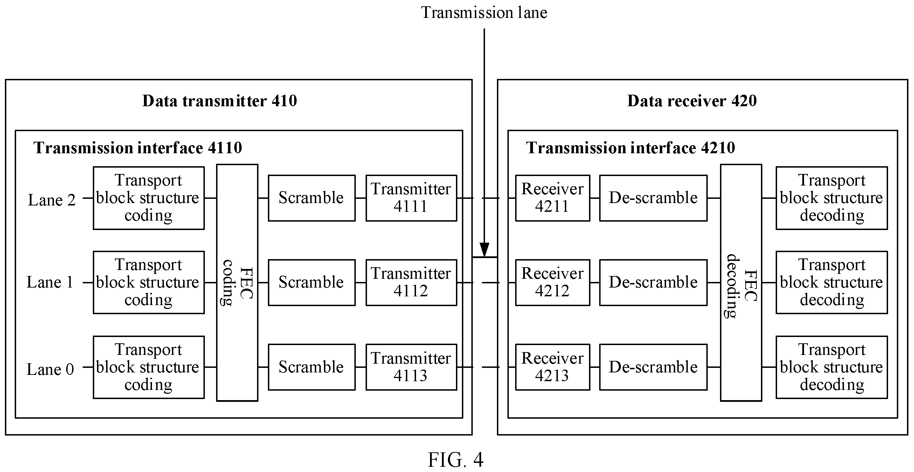

Refer to FIG. 4. FIG. 4 is a schematic diagram of a system architecture according to an embodiment of this application. As shown in FIG. 4, the system includes a data transmitter 410 and a data receiver 420. The data transmitter may be specifically a set top box, a monitor, or the like. A transmission interface on the data transmitter 410 may flexibly select a quantity of transmission lanes based on a service requirement, and perform FEC encoding on to-be-sent data. The data receiver 420 may be specifically a television, a display, or the like. The data receiver 420 receives data from a transmission lane, and performs FEC decoding and error check and correction on the received data. The data transmitter 410 transmits the to-be-sent data to a transmission interface 4110, where the transmission interface 4110 includes a plurality of transmission lanes, for example, a transmission lane 0, a transmission lane 1, and a transmission lane 2. Transport block structure coding is first performed on data on each transmission lane. The data on each transmission lane is processed into periodic transport blocks, and then FEC coding is performed, that is, data on a plurality of transmission lanes is cross-mapped to a plurality of FEC working areas. It should be noted that, a quantity of FEC working areas is the same as a quantity of transmission lanes. The data on each transmission lane is evenly allocated to the plurality of FEC working areas, and an amount of data received in each FEC working area in a unit time is the same. Calculation is performed by using the FEC working area on the data to obtain a plurality of check bits, and then the data in the FEC working area is remapped to each transmission lane. It should be understood that a plurality of check bits obtained through calculation in each FEC working area are also cross-mapped to each transmission lane. After FEC coding is completed, a scrambling operation is performed on the data on each transmission lane to increase the non-coherent capability of the transmission channel to transmit data, and finally through a transmitter, such as a transmitter 4111, a transmitter 4112, and a transmitter 4113, the data on each transmission lane is sent to the data receiver 420 by using the transmission channel. The data receiver 420 receives the data sent by the data transmitter 410 by using a plurality of receivers in the transmission interface 4210, for example, a receiver 4211, a receiver 4212, and a receiver 4213, and then performs a descrambling operation on the data on each transmission lane. After the descrambling operation is completed, FEC decoding is performed, that is, data on a plurality of transmission lanes is cross-mapped to a plurality of FEC working areas, each FEC working area uses a plurality of check bits to perform check and error correction on the data, and then data obtained after the check bits are removed is cross-mapped to each transmission lane again. Finally, transport block structure decoding is performed on the data on each transmission lane, and transport blocks on each transmission lane are reprocessed into data streams. In this way, an entire data receiving procedure is completed.

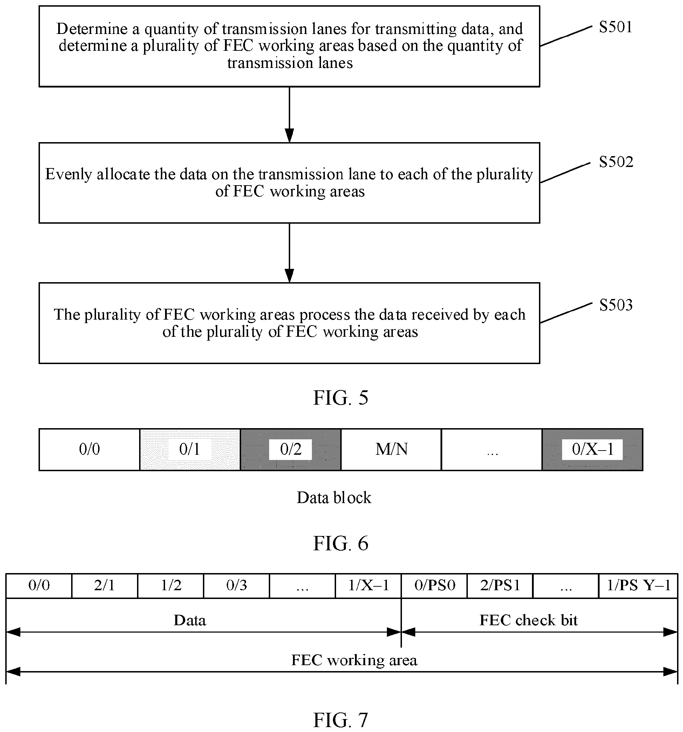

Based on the foregoing description, the following describes a forward error correction code FEC design method and a related device provided in embodiments of this application. Refer to FIG. 5. FIG. 5 is a schematic flowchart of an FEC design method according to an embodiment of this application. A data transmitter and a data receiver described in FIG. 5 may respectively correspond to the data transmitter 410 and the data receiver 420 shown in FIG. 4. As shown in FIG. 5, the method includes but is not limited to the following steps:

S501: Determine a quantity of transmission lanes for transmitting data, and determine a plurality of FEC working areas based on the quantity of transmission lanes.

Specifically, a transmission interface of the data transmitter may flexibly select a quantity of transmission lanes based on a service requirement. For example, SD, HD, and 4K video data may be transmitted by using an HDMI. In this case, the data transmitter selects different quantities of transmission lanes to meet the service requirement. Therefore, before the data is sent, the quantity of transmission lanes for transmitting data needs to be determined first.

Further, after the quantity of transmission lanes is determined, a quantity of FEC working areas matching the transmission lanes needs to be determined. It should be noted that, in a manufacturing process of the transmission interface of the data transmitter, a plurality of FEC working areas are manufactured in advance to ensure sufficient redundancy, to meet requirements of different scenarios. For example, 10 FEC working area circuits may be manufactured in advance in a design and manufacturing process. In this case, the transmission interface may support a maximum quantity of 10 transmission lanes. In this way, it can be ensured that the transmission interface meets requirements of various scenarios. Certainly, a quantity of redundant FEC working area circuits may also be set to another value. This is not limited in this application.

S502: Evenly allocate the data on the transmission lane to each of the plurality of FEC working areas.

Specifically, the data transmitted on each transmission lane may be referred to as a data stream. To facilitate subsequent processing on the data stream, the data stream may be divided in a unit of X characters, to obtain a plurality of data blocks. A value of X may be flexibly set based on a requirement. This is not limited in this application. It should be noted that, the data stream on the transmission lane is generally divided based on an amount of data processed by each FEC working area at a time, that is, a value of X is equal to an amount of data processed by each FEC working area at a time. The amount of data processed by the FEC working area at a time is the amount of data received by the FEC working area in a unit time.

For example, as shown in FIG. 6, FIG. 6 represents a process of data stream division on a transmission lane to obtain a data block. Each small block in the figure represents a data unit, and M/N represents an N^{th} data unit in a data block on a lane M. For example, 0/0 represents a 0^{th} data unit in a data block on a lane 0, and 0/2 represents a second data unit in a data block on a lane 0.

It should be understood that, in a process of evenly allocating data on a transmission lane to a plurality of FEC working areas, it needs to be ensured that an amount of data received by each FEC working area in a unit time is the same. For example, there are three transmission lanes and three FEC working areas. One data block on each transmission lane includes 100 characters. In this case, when allocation is performed, 300 characters included in three data blocks need to be allocated to three FEC working areas at the same time, so that 100 characters are allocated to each FEC working area. In addition, during specific allocation, a transmission lane is not in a one-to-one correspondence with an FEC working area, and all characters included in a data block on a transmission lane are allocated to an FEC working area. In this way, all data processed by the FEC working area comes from a same transmission lane. Instead, characters included in one data block on any transmission lane are allocated to a plurality of FEC working areas one by one, so that each FEC working area processes some data of the data block. For example, in FIG. 6, each small block has a different color, indicating that the data unit will be allocated to a different FEC working area.

S503: The plurality of FEC working areas process data received by the plurality of FEC working areas.

Specifically, after receiving the data allocated by each transmission lane, each FEC working area starts to process the data. The amount of data processed each time is X characters.

It should be noted that, if the FEC working area is an FEC working area of a data transmit end, the FEC working area performs calculation on the received X characters to obtain Y FEC check bits, and the Y FEC check bits are separately mapped to each transmission lane. For example, the Y check bits may be separately mapped to a plurality of transmission lanes one by one, and then cyclic mapping is performed for a plurality of times until mapping of the Y check bits is completed. A specific process is similar to that of allocating characters on a transmission lane to an FEC working area, and reference may be made to the method described above. Details are not described herein again. A value of Y is related to a selected check algorithm. If different check algorithms are used, values of Y obtained through calculation may be different. A specific selected check algorithm is not limited in this application.

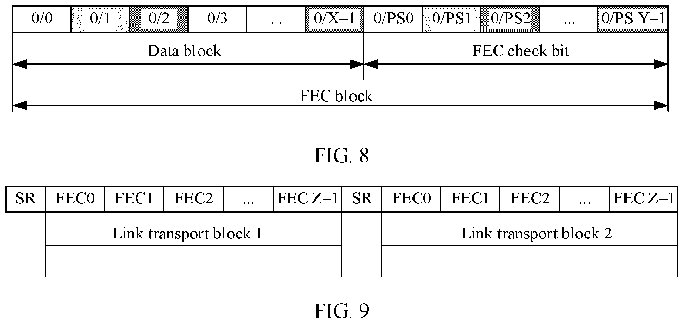

For example, as shown in FIG. 7, the FEC working area receives data allocated by each transmission lane. For example, a 0^{th} data unit in a data block on a lane 0 (that is, 0/0), a first data unit in a data block on a lane 2 (that is, 2/1), and a second data unit in a data block on a lane 1 (that is, 1/2). Then, calculation is performed on the data to obtain Y FEC check bits, where M/PS N represents an FEC check bit, and the check bit is mapped to an N^{th} FEC check bit on a lane M. The Y FEC check bits obtained through performing calculation by the FEC working area are mapped to different transmission lanes. In addition, to process data more conveniently and simplify a data processing process, a data stream transmitted on each transmission lane may be further divided in structure. Specifically, for each transmission lane, a data structure formed by X characters included in each data block and Y FEC check bits obtained by mapping from each FEC working area is referred to as an FEC block. A specific structure of an FEC block is shown in FIG. 8. 0/0 indicates a 0^{th} data unit in an FEC block on a lane 0, and 0/PS 0 indicates a 0^{th} check bit in an FEC block on a lane 0.

Correspondingly, if the FEC working area is an FEC working area of a data receive end, the data received by the FEC working area includes X characters and Y FEC check bits that are allocated from each transmission lane (that is, the total amount of data received by the FEC working area is the same as the amount of data received by an FEC block.). The FEC working area uses the Y FEC check bits to perform check and error correction on the X characters. A specific check and error correction process is similar to that of an existing check and error correction algorithm, and details are not described herein again.

Further, to perform processing such as character delimitation, link transport block delimitation, inter-lane alignment, and initializing a scrambling seed on data transmitted on each transmission lane, a data sequence, that is, a scramble reset sequence (scramble reset sequence, SR), needs to be inserted between link transport blocks transmitted on the transmission lane, where one link transport block (link transport block, LT Block) includes Z FEC blocks, and a value of Z may be set based on a requirement. This is not limited in this application. It should be noted that the SR inserted between two LT blocks is not encoded, that is, data in the SR is not allocated to the FEC working area for processing. For example, a data structure transmitted on a transmission lane is shown in FIG. 9. An SR is inserted between a link transport block 1 and a link transport block 2, and both include Z FEC blocks.

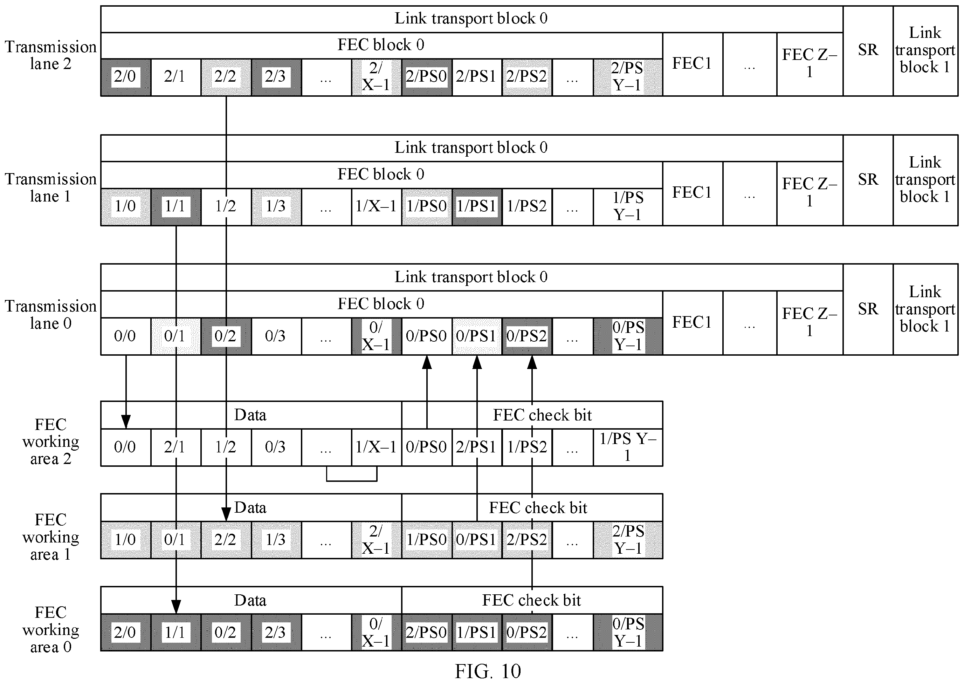

To better describe a mapping relationship between an FEC working area and data on a transmission lane, an example in which a transmission interface includes three transmission lanes, and uses three FEC working areas is used for description. As shown in FIG. 10, data arrangement structures on the transmission lane 0, the transmission lane 1, and the transmission lane 2 are the same, and different link transport blocks are separated by using an SR as a link transport block boundary. Each link transport block includes Z FEC blocks. Each FEC block includes X characters and Y FEC check bits. Each time an FEC working area 0, an FEC working area 1, and an FEC working area 2 receive X characters mapped from a transmission lane 0, a transmission lane 1, and a transmission lane 2, the Y FEC check bits are obtained through calculation. 0 to X-1 indicate data characters allocated by the transmission lane. PS0 to PSY-1 indicates the Y check bits obtained through calculation based on the 0 to X-1 characters. The arrow from the FEC block on the transmission lane to the FEC working area indicates that data of different FEC blocks is mapped to different FEC working areas. For example, the 0^{th} data unit of the FEC block 0 on a transmission lane 0 is mapped to the FEC working area 2, the first data unit of the FEC block 0 on the transmission lane 1 is mapped to the FEC working area 0, and the second data unit of the FEC block 0 on the transmission lane 2 is mapped to the FEC working area 1. The arrow from the FEC working area to the FEC block on the transmission lane indicates that FEC parity bits obtained through calculation by different FEC working areas are mapped to different FEC blocks. For example, a second check bit on the FEC working area 0 is mapped to the second FEC check bit of the FEC block 0 on the transmission lane 0, a first check bit on the FEC working area 1 is mapped to the first FEC check bit of the FEC block 0 on the transmission lane 0, and a 0^{th} check bit on the FEC working area 2 is mapped to the 0^{th} FEC check bit of the FEC block 0 on the transmission lane 0.

It can be learned that, when a quantity of used FEC working areas matches a quantity of transmission lanes used by the transmission interface, the amount of data processed by each FEC working area is the same. Therefore, sizes of FEC blocks on each transmission lane are fixed and the same. Link transport block boundaries on each transmission lane are also the same, that is, data arrangement structures on each transmission lane are the same. In this way, an interface circuit scale and design complexity can be effectively reduced, and production costs can be reduced.

Based on the foregoing FEC block structure and the LT block structure, a transmission interface that includes two transmission lanes and that can flexibly select a quantity of lanes to transmit data based on a requirement is used as an example to describe a data processing process in a mode in which different quantities of lanes are used.

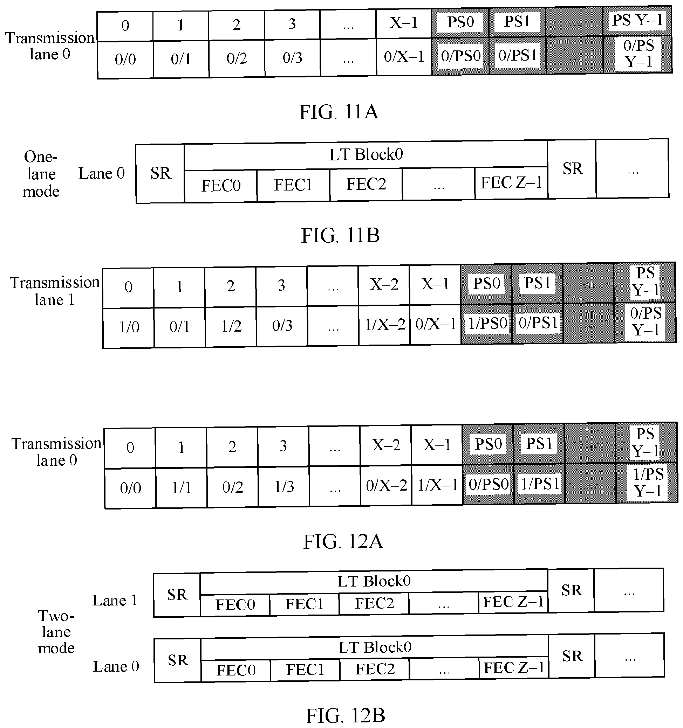

As shown in FIG. 11A, in a one-lane mode, X to-be-encoded characters included in an FEC block on a lane 0 are sequentially sent to an FEC working area 0 for processing, and Y FEC check bits are obtained through calculation by the FEC working area 0. The Y FEC check bits are inserted after the FEC block immediately following the lane 0, and a data structure of the final transmission is shown in FIG. 11B. In a two-lane transmission mode, data of the FEC blocks of the two lanes is interleaved to the FEC working area 0 and the FEC working area 1. As shown in FIG. 12A, X to-be-encoded characters included in the FEC block on the lane 0 are evenly allocated to the FEC working area 0 and the FEC working area 1 for processing. For example, a 0^{th} character is sent to the FEC working area 0, and the first character is sent to the FEC working area 1. Similarly, X to-be-encoded characters included in the FEC block on the lane 1 are also evenly allocated to the FEC working area 0 and the FEC working area 1 for processing. For example, the 0^{th} character is sent to the FEC working area 1, and the first character is sent to the FEC working area 0. After the FEC working area 0 and the FEC working area 1 complete data processing, after the Y FEC check bits obtained through calculation are evenly mapped to the FEC blocks on the lane 0 and the lane 1, a data structure of the transmission is shown in FIG. 12B. Data arrangement structures on the two lanes are the same, SR locations are also the same, and an amount of data included in each link transport block on the lane 0 is the same as an amount of data included in each link transport block on the lane 1.

Based on the foregoing description, it can be found that, in the one-lane transmission mode, data on one transmission lane is allocated to one FEC working area, and in the two-lane transmission mode, data on two transmission lanes is allocated to two FEC working areas. Therefore, for each FEC working area, no matter which lane transmission mode is selected, the amount of data received in a unit time is the same. Therefore, no matter whether one-lane transmission or two-lane transmission are used, or even more transmission lanes are used for transmission, an amount of data and a boundary of an FEC block of each lane, an amount of data and a boundary of an LT block, and a periodicity of each lane are the same, that is, a data arrangement structure of each lane is the same, so that data processing can be easily performed by using a unified circuit, an interface circuit scale and design complexity can be reduced, and production costs are effectively reduced.

The methods in embodiments of this application are described in detail above. For ease of better implementing the solutions in embodiments of this application, correspondingly, related device used to cooperate in implementing the solutions are further provided below.

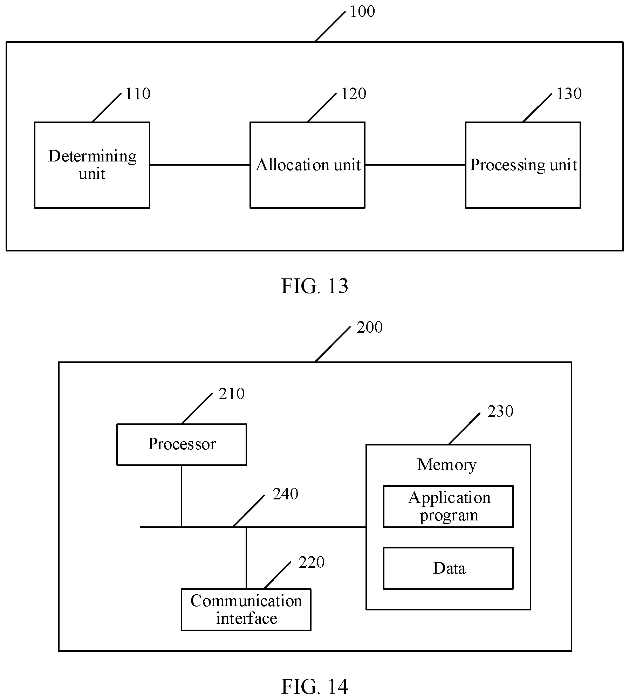

Refer to FIG. 13. FIG. 13 is a schematic structural diagram of a data processing apparatus according to an embodiment of this application. A data processing apparatus 100 includes a determining unit 110, an allocation unit 120, and a processing unit 130. Specifically,
the determining unit 110 is configured to determine a quantity of transmission lanes for transmitting data, and determine a plurality of FEC working areas based on the quantity of transmission lanes, where a quantity of the plurality of FEC working areas is the same as the quantity of transmission lanes, the transmission lane is for transmitting the data, and the FEC working area is for performing check and error correction on the data;
the allocation unit 120 is configured to evenly allocate the data on the transmission lane to each of the plurality of FEC working areas; and
the processing unit 130 is configured to process, by using the plurality of FEC working areas, the data received by each of the plurality of FEC working areas.

In an embodiment, the allocation unit 120 is specifically configured to: divide the data on each transmission lane to obtain a plurality of data blocks, where each data block includes X characters, and X is a positive integer greater than 1; and evenly allocate the X characters included in each data block to the plurality of FEC working areas.

In an embodiment, the processing unit 130 is specifically configured to: if the plurality of FEC working areas are in an encoding state, perform, by using each of the plurality of FEC working areas, calculation each time the X characters are received, to obtain Y FEC check bits corresponding to the X characters; or if the plurality of FEC working areas are in a decoding state, perform, by using each of the plurality of FEC working areas, check and error correction on the X characters by using Y FEC check bits corresponding to every received X characters.

In an embodiment, the processing unit 130 is further configured to insert a data sequence between transport blocks transmitted on each of the transmission lanes, where the transport block includes Z data blocks, the data sequence is for delimiting the data transmitted on the transmission lane, and Z is a positive integer greater than 1.

It may be understood that the determining unit 110, the allocation unit 120, and the processing unit 130 in embodiments of this application may be implemented by a processor or a circuit component related to a processor. The data processing apparatus may perform the steps performed by the data transmitter or the data receiver in the method shown in FIG. 5. Details are not described herein again. For details, refer to FIG. 5 and related content.

Refer to FIG. 14. FIG. 14 is a schematic structural diagram of a data processing apparatus according to an embodiment of this application. As shown in FIG. 14, a data processing apparatus 200 includes: a processor 210, a communication interface 220, and a memory 230. The processor 210, the communication interface 220, and the memory 230 are connected to each other by using an internal bus 240.

The data processing apparatus 200 may be a data transmitter or a data receiver in FIG. 4. A function performed by the data transmitter or the data receiver in FIG. 4 are actually performed by the processor 210 of the data transmitter or the data receiver.

The processor 210 may include one or more general-purpose processors, for example, a central processing unit (central processing unit, CPU), or a combination of a CPU and a hardware chip. The hardware chip may be an application-specific integrated circuit (application-specific integrated circuit, ASIC), a programmable logic device (programmable logic device, PLD), or a combination thereof. The PLD may be a complex programmable logic device (complex programmable logic device, CPLD), a field-programmable gate array (field-programmable gate array, FPGA), generic array logic (generic array logic, GAL), or any combination thereof.

The bus 240 may be a peripheral component interconnect (peripheral component interconnect, PCI) bus, an extended industry standard architecture (extended industry standard architecture, EISA) bus, or the like. The bus 240 may be classified into an address bus, a data bus, a control bus, and the like. For ease of representation, only one bold line is used to represent the bus in FIG. 14, but this does not mean that there is only one bus or only one type of bus.

The memory 230 may include a volatile memory (volatile memory), for example, a random access memory (random access memory, RAM). The memory 230 may also include a non-volatile memory (non-volatile memory), for example, a read-only memory (read-only memory, ROM), a flash memory (flash memory), a hard disk drive (hard disk drive, HDD), or a solid-state drive (solid-state drive, SSD). The memory 230 may further include a combination of the foregoing types. The program code may be used to implement the functional unit shown in the data processing apparatus 100, or is used to implement the method steps in the method embodiment shown in FIG. 5 that are performed by the data transmitter or the data receiver.

An embodiment of this application further provides a computer-readable storage medium. The computer-readable storage medium stores a computer program. When the program is executed by a processor, some or all of the steps described in any one of the foregoing method embodiments may be implemented, and a function of any functional unit described in FIG. 13 may be implemented.

An embodiment of this application further provides a computer program product. When the computer program product runs on a computer or a processor, the computer or the processor is enabled to perform one or more steps in any one of the foregoing methods. When the foregoing units in the device are implemented in a form of a software functional unit and sold or used as an independent product, the units may be stored in the computer-readable storage medium.

In the foregoing embodiments, the descriptions in embodiments have respective focuses. For a part that is not described in detail in an embodiment, refer to related descriptions in other embodiments.

It should be understood that sequence numbers of the foregoing processes do not mean execution sequences in various embodiments of this application. The execution sequences of the processes should be determined according to functions and internal logic of the processes, and should not be construed as any limitation on the implementation processes of embodiments of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

When the functions are implemented in the form of a software functional unit and sold or used as an independent product, the functions may be stored in a computer-readable storage medium. Based on such an understanding, the technical solutions of this application essentially, or the part contributing to the conventional technology, or some of the technical solutions may be implemented in a form of a software product. The computer software product is stored in a storage medium, and includes several instructions for instructing a computer device (which may be a personal computer, a server, or a network device) to perform all or some of the steps of the methods described in embodiments of this application. The foregoing storage medium includes: any medium that can store program code, such as a USB flash drive, a removable hard disk, a read-only memory (ROM, Read-Only Memory), a random access memory (RAM, Random Access Memory), a magnetic disk, or an optical disc.

The foregoing embodiments are merely intended for describing the technical solutions of this application, but not for limiting this application. Although this application is described in detail with reference to the foregoing embodiments, it should be appreciated by a person skilled in the art that, modifications may still be made to the technical solutions described in the foregoing embodiments, or equivalent replacements may be made to the part of the technical features; as long as such modifications or replacements do not cause the essence of corresponding technical solutions to depart from the scope of the technical solutions of embodiments of this application.

## Claims

1. A forward error correction code FEC design method, comprising:
determining a quantity of transmission lanes for transmitting data, and determining a plurality of FEC working areas based on the quantity of transmission lanes, wherein a quantity of the plurality of FEC working areas is the same as the quantity of transmission lanes, the transmission lane is for transmitting the data, and the FEC working area is for performing check and error correction on the data;
evenly allocating the data on the transmission lane to each of the plurality of FEC working areas; and
processing, by using the plurality of FEC working areas, the data received by each of the plurality of FEC working areas.

2. The method according to claim 1, wherein the evenly allocating the data on the transmission lane to each of the plurality of FEC working areas comprises:
dividing the data on each transmission lane to obtain a plurality of data blocks, wherein each data block comprises X characters, and X is a positive integer greater than 1; and
allocating the X characters comprised in each data block to the plurality of FEC working areas one by one.

3. The method according to claim 2, wherein the processing, by using the plurality of FEC working areas, the data received by each of the plurality of FEC working areas comprises:
if the plurality of FEC working areas are in an encoding state, performing, by using each of the plurality of FEC working areas, calculation each time the X characters are received, to obtain Y FEC check bits corresponding to the X characters; or
if the plurality of FEC working areas are in a decoding state, performing, by using each of the plurality of FEC working areas, check and error correction on the X characters by using YFEC check bits corresponding to every received X characters.

4. The method according to claim 2 or 3, wherein after the processing, by using the plurality of FEC working areas, the data received by each of the plurality of FEC working areas, the method further comprises:
inserting a data sequence between transport blocks transmitted on each of the transmission lanes, wherein the transport block comprises Z data blocks, the data sequence is for delimiting the data transmitted on the transmission lane, and Z is a positive integer greater than 1.

5. The method according to any one of claims 1 to 4, wherein a scramble reset sequence SR is comprised between the transport blocks transmitted on each of the transmission lanes, the transport block comprises Z FEC blocks, and the FEC block comprises the X characters and the Y FEC check bits, wherein X, Y, and Z are positive integers greater than 1.

6. A data processing apparatus, comprising:
a determining unit, configured to determine a quantity of transmission lanes for transmitting data, and determine a plurality of FEC working areas based on the quantity of transmission lanes, wherein a quantity of the plurality of FEC working areas is the same as the quantity of transmission lanes, the transmission lane is for transmitting data, and the FEC working area is for performing check and error correction on the data;
an allocation unit, configured to evenly allocate the data on the transmission lane to each of the plurality of FEC working areas; and
a processing unit, configured to process, by using the plurality of FEC working areas, the data received by each of the plurality of FEC working areas.

7. The data processing apparatus according to claim 6, wherein the allocation unit is specifically configured to:
divide the data on each transmission lane to obtain a plurality of data blocks, wherein each data block comprises X characters, and X is a positive integer greater than 1; and
evenly allocate the X characters comprised in each data block to the plurality of FEC working areas.

8. The data processing apparatus according to claim 7, wherein the processing unit is specifically configured to:
if the plurality of FEC working areas are in an encoding state, perform, by using each of the plurality of FEC working areas, calculation each time the X characters are received, to obtain Y FEC check bits corresponding to the X characters; or
if the plurality of FEC working areas are in a decoding state, perform, by using each of the plurality of FEC working areas, check and error correction on the X characters by using Y FEC check bits corresponding to every received X characters.

9. The data processing apparatus according to claim 7 or 8, wherein
the processing unit is further configured to insert a data sequence between transport blocks transmitted on each of the transmission lanes, wherein the transport block comprises Z data blocks, the data sequence is for delimiting the data transmitted on the transmission lane, and Z is a positive integer greater than 1.

10. The data processing apparatus according to any one of claims 6 to 9, wherein a scramble reset sequence SR is comprised between the transport blocks transmitted on each of the transmission lanes, the transport block comprises Z FEC blocks, and the FEC block comprises the X characters and the Y FEC check bits, wherein X, Y, and Z are positive integers greater than 1.

11. A data processing apparatus, wherein the apparatus comprises a processor and a transmission interface, and the processor is configured to invoke computer instructions stored in a memory, so that the apparatus performs the method according to any one of claims 1 to 5.

12. A computer-readable storage medium, wherein the computer-readable storage medium stores a computer program; and when the computer program is executed by a computer or a processor, the method according to any one of claims 1 to 5 is implemented.

13. A computer program product, wherein the computer program product comprises instructions; and when the instructions are executed by a computer or a processor, the method according to any one of claims 1 to 5 is implemented.
